Europäisches Patentamt

(19) European Patent Office

Office européen des brevets

(11) Veröffentlichungsnummer: **0 144 579**
**B1**

(12) **EUROPÄISCHE PATENTSCHRIFT**

(45) Veröffentlichungstag der Patentschrift:
14.10.87

(51) Int. Cl.⁴: **H 01 L 23/46**

(21) Anmeldenummer: 84111345.9

(22) Anmeldetag: 24.09.84

(54) Kühlkörper zur Flüssigkeitskühlung von Leistungshalbleiterbauelementen.

(30) Priorität: 02.11.83 CH 5919/83
08.11.83 CH 6013/83

(43) Veröffentlichungstag der Anmeldung:
19.06.85 Patentblatt 85/25

(45) Bekanntmachung des Hinweises auf die Patenterteilung:
14.10.87 Patentblatt 87/42

(84) Benannte Vertragsstaaten:
CH DE FR IT LI SE

(56) Entgegenhaltungen:
EP-A-0 050 774
WO-A-79/01012
DE-A-1 514 679
DE-A-2 640 000
DE-A-2 814 809
US-A-3 524 497

IBM TECHNICAL DISCLOSURE BULLETIN, Band 23,
Nr.11, April 1981, NEW YORK (US), Seiten 4954-4955;
R.CHRISTENSEN: "Rotable water-cooled heat
transfer plate"

(73) Patentinhaber: BBC Brown Boveri AG, CH- 5401
Baden (CH)

(72) Erfinder: Vogel, Xaver, Pfaffenziel 10, CH- 5300
Turgi (CH)

## Beschreibung

Bei der Erfindung wird ausgegangen von einem Kühlkörper zur Flüssigkeitskühlung von Leistungshalbleiterbauelementen nach dem Oberbegriff des Patentanspruchs 1.

Mit diesem Oberbegriff nimmt die Erfindung auf einen Stand der Technik Bezug, wie er in der DE-A- 2 402 606 beschrieben ist. Dort ist ein Kühlkörper für scheibenförmige Halbleiter angegeben, bei dem eine Kühlflüssigkeit durch eine axiale Bohrung grossen Durchmessers über engere Verbindungskanäle in waffelförmige Ausnehmungen strömt, welche bis zu dem Abschlussboden des Halbleiterbauelementes führen und somit dessen unmittelbare Kühlung ermöglichen. Von dort strömt die Kühlflüssigkeit durch einen randseitigen Ringkanal und eine Auslassbohrung radial nach aussen in einen den Kühlkörper umgebenden Raum.

Die Erfindung, wie sie in Patentansprüchen gekennzeichnet ist, löst die Aufgabe, einen Kühlkörper so auszubilden, dass der Kühleffekt der Kühlflüssigkeit verbessert wird, wobei die konstruktive Ausgestaltung möglichst einfach sein soll.

Ein Vorteil der Erfindung liegt darin, dass ein besser gekühlter Halbleiter elektrisch höher belastet werden kann, d.h., dass höhere Durchlassströme erreicht werden können. Durch vergrösserte Wärmeaustauschflächen am randseitigen Aussenumfang des Kühlkörpers in Gestalt von Kühlrippen, -zapfen usw. kann pro Zeiteinheit bedeutend mehr Wärme abgeleitet werden, als ohne diese Massnahme.

Gemäss einer vorteilhaften Ausgestsltung der Erfindung kann die Kühlwirkung durch gezieltes und verstärktes Umströmen der Kühlrippen des Kühlkörpers verbessert werden. Dabei strömt die Kühlflüssigkeit mit einer Tangentialkomponente aus den Kühlschlitzen in den umgebenden Raum aus und führt dabei zusätzlich Wärme von dem Kühlkörper ab. Damit konnte bei Ölkühlung der Wärmewiderstand im Vergleich zu einem Kühlkörper, bei dem keine Kühlrippen, -zapfen usw. und keine verstärkte Umströmung vorhanden waren, sondern nur die Halbleiterauflagefläche mit Kühlflüssigkeit gekühlt wurde, auf 1/3 erniedrigt werden.

Es ist vorteilhaft, die Kühlschlitze mit rechteckigem Profil auszuführen. Dieses Profil ist herstellungstechnisch sehr einfach. Gemäss einer Weiterbildung des Erfindungsgegenstandes sind die Kühlschlitze mit einem von der rechteckigen Form abweichenden Profil ausgebildet, z. B. dreieckig, mit halbrundem Bogen oder trapezförmig.

Das Profil der Kühlschlitze kann also praktisch beliebig den jeweiligen Anforderungen angepasst werden.

Die Serpentine- oder Evolventenform der Kühlschlitze ist besonders dann zweckmässig, wenn die Kühlschlitze von der parallelen gegenseitigen Lage abweichen, z. B. radial angeordnet sind. Die radiale Anordnung der Kühlschlitze ist für eine zylindrische Form des Kühlkörpers geeignet, wobei selbstverständlich der Durchmesser des zylindrischen Kühlkörpers dem Durchmesser der zu kühlenden Fläche angepasst ist.

Bei einer spiralförmigen Ausbildung der Kühlschlitze ist die Kühlflüssigkeit über eine relativ lange Wegstrecke mit dem Kühlelement in Kontakt, so dass eine besonders effektive Kühlung erreicht wird. Durch das Ausströmen der Kühlflüssigkeit unter einem Winkel zur radialen Richtung wird in der Umgebung des Kühlkörpers die Turbulenz der Kühlflüssigkeit verstärkt und damit eine verbesserte Kühlung bewirkt.

Für normale Funktionsweise reicht ein konstantes Profil der Kühlschlitze aus. In einigen Fällen ist es zweckmässig, die Kühlschlitze mit einem sich erweiternden Profil auszubilden. Durch die Veränderung der Profilgrösse verändert man auch die Strömungsgeschwindigkeit der Kühlflüssigkeit.

Eine weitere Verbesserung der Kühlwirkung lässt sich dadurch erzielen, dass innerhalb der Kühlschlitze für eine Turbulenz der Kühlflüssigkeit gesorgt wird durch Ausnehnungen an den Kühlschlitzrändern und/oder durch ein Anordnen von Verwirbelungskörpern innerhalb der Kühlschlitze.

Die Erfindung wird nachstehend anhand einiger schematisch dargestellter Beispiele näher erläutert. Es zeigen:

Fig. 1 eine Draufsicht auf einen Kühlkörper,

Fig. 2 einen Kühlkörper gemäss Fig. 1 im Querschnitt, der den Sammelkanal für die Zufuhr der Kühlflüssigkeit und eine Bohrung für den elektrischen Anschluss erkennen lässt,

Fig. 3 einen zylindrischen Kühlkörper, bei dem in 4 Segmenten 4 verschiedene Ausbildungsvarianten der Kühlschlitze dargestellt sind, und

Fig. 4 eine Draufsicht auf die Kontaktierungsfläche eines Kühlkörpers gemäss den Fig. 1 und 2.

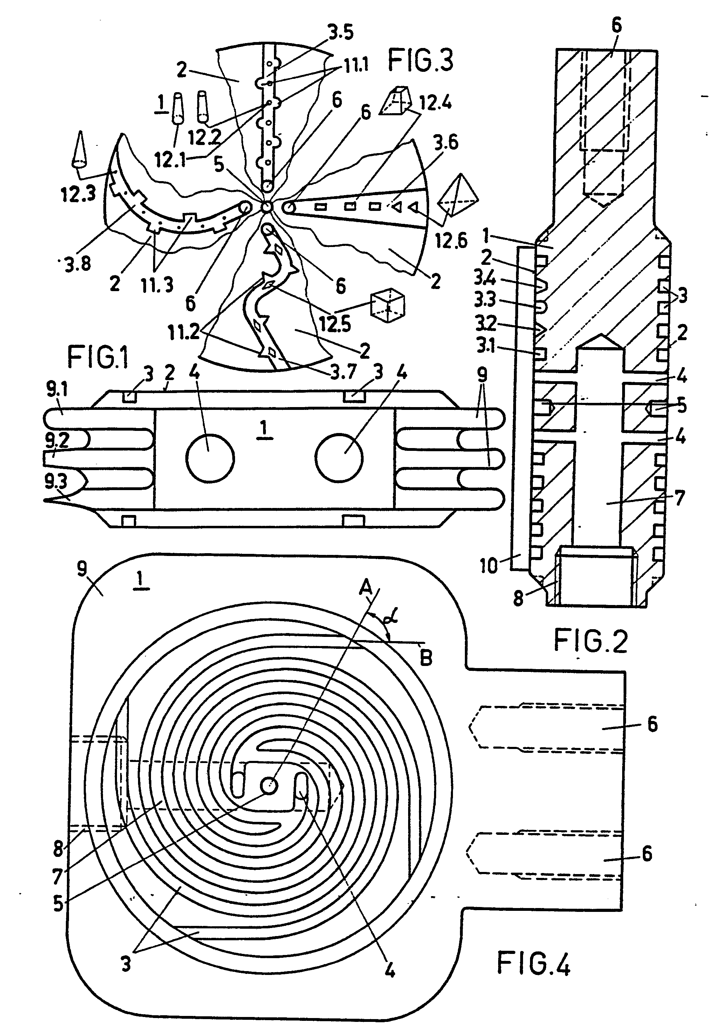

Gemäss den Fig. 1 und 2 ist ein scheibenförmiger Kühlkkörper 1 mit zwei Halbleiterauflageflächen 2 versehen. In jeder dieser Halbleiterauflageflächen 2 sind mehrere parallele Kühlschlitze 3 ausgeführt, die ein rechteckiges Profil 3.1 oder ein dreieckiges Profil 3.2 oder ein Profil mit halbrundem Boden 3.3 oder ein trapezförmiges Profil 3.4 aufweisen können. Der Einfachheit halber sind in Fig. 3 diese verschiedenen Profile an einem Kühlkörper dargestellt; in der Praxis kommt vorzugsweise nur eines dieser Profile sn einem Kühlkörper zur Anwendung.

Die Kühlschlitze 3 sind mittels je zweier Verbindungskanäle 4 mit einem Sammelkanal 7 verbunden. Mit der Bezugsziffer 5 sind Zentrierlöcher bezeichnet. Das Ende des Sammelkanals 7 ist mit einem Gewinde 8 versehen. Eine Bohrung 6 dient für den elektrischen Anschluss des Kühlkörpers 1.

Mit 9 sind Kühlelemente bezeichnet, die als flächenhafte Kühlrippen 9.1 oder sls eine Reihe einzelner Kühlzapfen 9.2 oder als Kühlnadeln 9.3 ausgeführt sein können. Die Kühlzapfen sind stabförmig oder pyramidenstumpfförmig ausgebildet und weisen vorzugsweise einen rhombischen oder quadratischen Querschnitt auf, wobei die Diagonale quer zur Hauptströmungsrichtung der Kühlflüssigkeit ausgerichtet ist. Die Kühlzapfen benachbarter Reihen sind vorteilhaft gegeneinander versetzt, so dass eine gute Verwirbelung der vorbeiströmenden Kühlflüssigkeit erfolgt. Wesentlich ist, dass die Kühlelemente relativ grosse Wärmeableitflächen aufweisen, um die abzuführende Wärme gut an die Kühlflüssigkeit ableiten zu können. Der Kühlkörper mit den Kühlelementen 9 besteht aus einem gut wärmeleitenden Metall, wie z. B. Kupfer, Aluminium oder deren Legierungen.

In Fig. 2 ist der Einfachheit halber nur ein scheibenförmiges Leistungshalbleiterbauelement 10 eingezeichnet, das direkt über die Halbleiterauflagefläche 2 und über die Kühlflüssigkeit, die bei Betrieb durch die Kühlschlitze 3 strömt, gekühlt wird. Von den randseitigen Kühlschlitzen 3, die in den Bereich der Abschrägung fallen, strömt die Kühlflüssigkeit frei in einen nicht dargestellten Kühlflüssigkeitsbehälter. Sie wird dem Sammelkanal 7 unter Druck zugeführt. In dem Kühlflüssigkeitsbehälter können mehrere zu kühlende Baugruppen nebeneinander oder hintereinander angeordnet sein. Diese Baugruppen bestehen in der Leistungselektronik in der Regel aus einer sandwichartigen Folge von Kühlkörper, Leistungshalbleiter, Kühlkörper, Leistungshalbleiter, Kühlkörper usw. Die scheibenförmigen Bauelemente einer Baugruppe werden mittels einer nicht dargestellten Einspannvorrichtung gegeneinander gepresst, so dass zwischen ihnen ein guter elektrischer und Wärmeleitungskontakt besteht.

Die Draufsicht von Fig. 4 zeigt spiralförmig angeordnete Kühlschlitze 3 mit Kühlelementen 9 und mit zwei Bohrungen 6 für elektrische Anschlüsse an einem Kühlkörper 1 gemäss den Fig. 1 und 2. Die Kühlschlitze 3 weisen am äusseren Kühlkörperrand einen Flüssigkeitsausströmwinkel α im Bereich von 40° bis 90°, vorzugsweise von 60° bis 70° auf, wobei α zwischen einer radialen Achse A und einer Kühlschlitzachse B am Flüssigkeitsaustrittsende gemessen wird. Damit wird erreicht, dass die Kühlflüssigkeit, vorzugaweise Öl, zwischen und an den Kühlelementen 9 am Aussenrand des Kühlkörpers 1 vorbeiströmt und von diesen Kühlelementen Wärme abführt.

Fig. 3 zeigt ausschnittsweise 4 Ausführungsformen von Kühlschlitzen 3 in Kühlkörpern 1. Die Kühlschlitze 3 sind in zwei Fällen radial und in weiteren zwei Fällen im wesentlichen radial geführt. Sie sind mit dem in dieser Fig. 3 nicht dargestellten Sammelkanal 7 mittels Verbindungskanälen 6 verbunden. Wie ersichtlich, wird die Flüssigkeit in das Zentrum des Kühlkörpers 1 geführt, wovon sie dann zu dem äusseren Rand des Kühlkörpers 1 fliesst. Ein Kühlschlitz 3.5 ist geradlinig ausgebildet, ein weiterer Kühlschlitz 3.6 weist einen sich nach aussen erweiternden Querschnitt auf, ein Kühlschlitz 3.7 ist serpentineartig ausgeführt und ein Kühlschlitz 3.8 weist eine Evolventenform auf. Die zwei letztgenannten Kühlschlitze 3.7 und 3.8 werden selbstverständlich mit weiteren ähnlich ausgebildeten Kühlschlitzen kombiniert, die regelmässig über die Halbleiterauflagefläche 2 verteilt sind.

Um eine bessere Verwirbelung der Kühlflüssigkeit innerhalb der Kühlschlitze und damit eine bessere Wärmeübertragung vom Kühlkörper 1 an die Kühlflüssigkeit zu erzielen, weisen die Kühlschlitze 3.5 ... 3.8 an den Schlitzrändern Ausbuchtungen oder Ausnehmungen 11.1 ... 11.3 auf, die gegeneinander versetzt angeordnet sind. Diese Ausnehmungen sind vorzugsweise halbkreisförmig, 11.1, oder dreieckförmig, 11.2, oder rechteckförmig, 11.3, ausgeführt.

Eine weitere Verbesserung der Verwirbelung und der Kühlwirkung wird dadurch erreicht, dass in die Kühlschlitze 3 Verwirbelungselemente bzw. Verwirbelungskörper 12.1 ... 12.6 hineinragen, die vorzugsweise kegelformig, 12.1, oder zylindrisch, 12.2, oder nadelförmig, 12.3, oder pyramidenförmig, 12.4, oder prismatisch, 12.5, oder tetraedrisch, 12.6, ausgeführt sind. In Fig. 3 sind die unterschiedlichen Formen der Verwirbelungskörper perspektivisch dargestellt. Die unterschiedlichen Verwirbelungskörper und Ausnehmungen können auch kombiniert in einem Kühlkörper 1 angewendet werden.

Es ist selbstverständlich, dass der Erfindungsgegenstand auf das in den Zeichnungen Dargestellte nicht beschränkt ist. Es können andere Profile und Formen der Kühlschlitze 3 verwendet werden. Der Kühlkörper 1 kann auch nur einseitig mit den Kühlschlitzen 3 versehen sein, wenn es sich um einen Kühlkörper 1 handelt, der nur ein Halbleiterbauelement kühlen soll. Der Kühlkörper 1 kann auch andere Formen aufweisen.

**Patentansprüche**

1. Kühlkörper (1) zur Flüssigkeitskühlung von Leistungshalbleiterbauelementen (10)
   a) mit mindestens einem Sammelkanal (7) für die Zufuhr einer Kühlflüssigkeit,
   b) der mit Kühlschlitzen (3) verbunden ist,
   c) welche in mindestens einer ebenen Halbleiterauflagefläche (2) ausgebildet sind und
   d) randseitig am Kühlkörper eine freie Flüssigkeitsaustrittsöffnung aufweisen,
   dadurch gekennzeichnet,
   e) dass der Kühlkörper (1) randseitig Kühlelemente (9, 9.1, 9.2, 9.3) aufweist.

2. Kühlkörper nach Anspruch 1, dadurch gekennzeichnet, dass die Kühlelemente (9) als Kühlrippen (9.1), oder Kühlzapfen (9.2) oder Kühlnadeln (9.3) ausgebildet sind.

3. Kühlkörper nach Anspruch 1 oder 2, dadurch gekennzeichnet, dass die Kühlschlitze (3) ein
   a) rechteckförmiges oder
   b) dreieckförmiges oder
   c) halbrundes oder
   d) trapezförmiges Profil aufweisen.

4. Kühlkörper nach einem der Ansprüche 1 bis 3, dadurch gekennzeichnet, dass die Kühlschlitze (3) wenigstens abschnittsweise
   a) serpentineförmig (3.7) oder
   b) evolventenförmig (3.8) oder
   c) spiralförmig ausgebildet sind.

5. Kühlkörper nach einem der Ansprüche 1 bis 3, dadurch gekennzeichnet, dass die Kühlschlitze (3) ein sich in radialer Richtung nach aussen erweiterndes Profil (3.6) aufweisen.

6. Kühlkörper nach einem der Ansprüche 1 bis 4, dadurch gekennzeichnet, dass der Ausströmwinkel (α) der Kühlflüssigkeit aus den Kühlschlitzen (3) im Bereich von 40° bis 90°, insbesondere im Bereich von 60° bis 70° liegt, wobei der Austrittswinkel (α) am Austritt der Kühlflüssigkeit aus den Kühlschlitzen in den den Kühlkörper randseitig umgebenden Raum den Winkel zwischen radialer Achse (A) und Külschlitzachse (B) am Flüssigkeitsaustrittsende der Kühlschlitze (3) bedeutet.

7. Kühlkörper nach einem der vorhergehenden Ansprüche, dadurch gekennzeichnet,
   a) dass die Kühlschlitze (3) an den Schlitzrändern Ausnehmungen (11.1 ... 11.3) aufweisen und/oder
   b) dass in die Kühlschlitze (3) Verwirbelungskörper (12.1 ... 12.6) ragen, zur Erzeugung einer Turbulenz der Kühlflüssigkeit in den Kühlschlitzen.

8. Kühlkörper nach Anspruch 7, dadurch gekennzeichnet, dass die Ausnehmungen (11.1 ... 11.3)
   a) halbkreisförmig (11.1) oder
   b) dreieckförmig (11.2) oder
   c) rechteckförmig (11.3) ausgebildet sind.

9. Kühlkörper nach Anspruch 7, dadurch gekennzeichnet, dass die Verwirbelungskörper (12.1 - 12.6)
   a) kegelförmig (12.1) oder
   b) zylindrisch (12.2) oder
   c) nadelförmig (12.3) oder
   d) pyramidenförmig (12.4) oder
   e) prismatisch (12.5) oder
   f) tetraedrisch (12.6) ausgebildet sind.

10. Kühlkörper nach einem der vorhergehenden Ansprüche, dadurch gekennzeichnet, dass er scheibenförmig ausgebildet ist.

## Claims

1. Heat sink (1) for liquid cooling of power semi-conductor components (10)
   a) with at least one collecting channel (7) for the supply of a cooling liquid,
   b) which collecting channel is connected to cooling slots (3),
   c) which are formed in at least one flat semi-conductor support surface (2) and
   d) have a free liquid exit opening at the edge of the heat sink,
   characterized in that,
   e) the heat sink (1) has cooling elements (9, 9.1, 9.2, 9.3) at the edge.

2. Heat sink according to Claim 1, characterized in that the cooling elements (9) are formed as cooling ribs (9.1), cooling lugs (9.2) or cooling needles (9.3).

3. Heat sink according to Claim 1 or 2, characterized in that the cooling slots (3) have a
   a) rectangular or
   b) triangular or
   c) semi-circular or
   d) trapezoidal profile.

4. Heat sink according to one of the Claims 1 to 3, characterized in that the cooling slots (3) are formed at least sectionwise with
   a) a winding shape (3.7) or
   b) an involute shape (3.8) or
   c) a spiral shape.

5. Heat sink according to one of the Claims 1 to 3, characterized in that the cooling slots (3) have a profile (3.6) which widens outwards in the radial direction.

6. Heat sink according to one of the Claims 1 to 4, characterized in that the discharge angle (α) of the cooling liquid from the cooling slots (3) is in the range from 40° to 90°, in particular in the range from 60° to 70°, the discharge angle (α) at the discharge of the cooling liquid from the cooling slots into the space surrounding the heat sink at the edge means the angle between the radial axis (A) and the axis (B) of the cooling slot at the liquid discharge end of the cooling slots (3).

7. Heat sink according to one of the preceding claims, characterized,
   a) in that the cooling slots (3) have recesses (11.1 ... 11.3) at the slot edges and/or
   b) in that turbulance bodies (12.1 ... 12.6) project into the cooling slots (3) to produce a turbulance of the cooling liquid in the cooling slots.

8. Heat sink according to Claim 7, characterized in that the recesses (11.1 ... 11.3) are formed with
   a) a semi-circular shape (11.1) or
   b) a triangular shape (11.2) or
   c) a rectangular shape (11.3).

9. Heat sink according to Claim 7, characterized in that the turbulance bodies (12.1 - 12.6) are formed with
   a) a conical shape (12.1) or
   b) a cylindrical shape (12.2) or
   c) a needle shape (12.3) or
   d) a pyramidal shape (12.4) or
   e) a prismatic shape (12.5) or
   f) a tetrahedral shape (12.6).

10. Heat sink according to one of the preceding claims, characterized in that it is formed with a disc shape.

## Revendications

1. Dissipateur thermique (1) pour le refroidissement par fluide de composants semiconducteurs de puissance (10)

   a) comportant au moins un canal collecteur (7) pour l'amenée d'un fluide réfrigérant,

   b) qui est raccordé à des fentes de refroidissement (3),

   c) qui sont ménagées dans au moins une surface d'appui plane (2) pour semi-conducteur, et

   d) qui présentent au niveau des bords du dissipateur thermique, une ouverture, par laquelle le fluide peut sortir librement, caractérisé en ce que,

   e) le dissipateur thermique (1) présente des éléments de refroidissement périphériques (9), (9.1), (9.2), (9.3).

2. Dissipateur thermique suivant la revendication 1, caractérisé en ce que les éléments de refroidissement (9) ont la forme de nervures de refroidissement (9.1), ou d'ergots de refroidissement (9.2), ou d'aiguilles de refroidissement (9.3).

3. Dissipateur thermique suivant la revendication 1 ou 2, caractérisé en ce que les fentes de refroidissement (3) présentent un profil

   a) rectangulaire ou

   b) triangulaire ou

   c) demi-rond ou

   d) trapézoïdal.

4. Dissipateur thermique suivant l'une quelconque des revendications 1 à 3, caractérisé en ce que les fentes de refroidissement (3) ont, au moins par sections,

   a) une forme sinueuse (3.7) ou

   b) une forme de développante (3.8) ou

   c) une forme spiralée.

5. Dissipateur thermique suivant l'une quelconque des revendications 1 à 3, caractérisé en ce que les fentes de refroidissement (3) présentent un profil (3.6) qui va en s'élargissant dans un sens radial dirigé vers l'extérieur.

6. Dissipateur thermique suivant l'une quelconque des revendications 1 à 4, caractérisé en ce que l'angle de sortie (α) du fluide réfrigérant sortant des fentes de refroidissement (3) est de l'ordre de 40 à 90°, en particulier de 60 à 70°, l'angle de sortie (α) à la sortie du fluide réfrigérant des fentes de refroidissement dans la chambre entourant périphériquement le dissipateur thermique étant l'angle formé entre l'axe radial (A) et l'axe de la fente de refroidissement (B) au niveau de l'extrémité de sortie du fluide des fentes de refroidissement (3).

7. Dissipateur thermique suivant l'une quelconque des revendications précédentes, caractérisé en ce que,

   a) les fentes de refroidissement (3) présentent des évidements (11.1 ... 11.3) au niveau des bords des fentes et/ou

   b) des corps de tourbillonnement (12.1 ... 12.6) font saillie dans les fentes de refroidissement (3) afin de produire une turbulence du fluide réfrigérant dans les fentes de refroidissement.

8. Dissipateur thermique suivant la revendication 7, caractérisé en ce que les évidements (11.1 ... 11.3) ont une forme

   a) semi-circulaire (11.1) ou

   b) triangulaire (11.2) ou

   c) rectangulaire (11.3).

9. Dissipateur thermique suivant la revendication 7, caractérisé en ce que les corps de tourbillonnement (12.1 ... 12.6) sont

   a) coniques (12.1) ou

   b) cylindriques (12.2) ou

   c) aciculaires (12.3) ou

   d) pyramidaux (12.4) ou

   e) prismatiques (12.5) ou

   f) tétraédriques (12.6).

10. Dissipateur thermique suivant l'une quelconque des revendications précédentes, caractérisé en ce qu'il est discoïde.

FIG.3

FIG.1

FIG.2

FIG.4